# EUROPEAN PATENT APPLICATION

(11) **EP 4 105 047 A1**
(43) Date of publication of application: **21.12.2022**
(21) Application number: 22275037.4
(22) Date of filing: 30.03.2022
(51) Int. Cl.: B60H 1/00, F25B 21/02, H01L 23/38, H01L 35/28, H05K 7/20

(54) **REFRIGERATION DEVICE AND VEHICLE**

(30) Priority: 18.06.2021 CN 202110680036
(71) Applicant: Apollo Intelligent Connectivity (Beijing) Technology Co., Ltd., Beijing 100176 (CN)
(72) Inventor: XING, Liang, BEIJING, 100176 (CN); SONG, Shuqing, BEIJING, 100176 (CN); WU, Yi, BEIJING, 100176 (CN); YANG, Wentao, BEIJING, 100176 (CN); ZHAO, Shuaishuai, BEIJING, 100176 (CN); LUO, Qionghua, BEIJING, 100176 (CN); WANG, Lifeng, BEIJING, 100176 (CN); FENG, Yunchan, BEIJING, 100176 (CN); WANG, Tao, BEIJING, 100176 (CN); CAO, Xiaochen, BEIJING, 100176 (CN); WU, Fuchuang, BEIJING, 100176 (CN)
(74) Representative: Wilson Gunn

(57) **Abstract**

A refrigeration device and a vehicle are provided, and relate to the technical field of vehicles. The refrigeration device is disposed in a trunk of the vehicle, and the refrigeration device includes: a semiconductor refrigeration sheet, having a cold end and a hot end which are disposed oppositely, wherein the hot end of the semiconductor refrigeration sheet is attached to an inner wall of the trunk, and the cold end of the semiconductor refrigeration sheet is disposed toward an inner space of the trunk.

## Description

### TECHNICAL FIELD

The present disclosure relates to the technical field of vehicles, and in particular to the technical field of refrigeration devices.

### BACKGROUND

A vehicle-mounted intelligent device of an automatic driving vehicle is usually disposed in a trunk. Because the vehicle-mounted intelligent device generates a large amount of heat in its working process, in order to improve the working stability of the vehicle-mounted intelligent device, it is necessary to install an auxiliary heat dissipation device in the trunk to dissipate the heat generated by the vehicle-mounted intelligent device.

In related technologies, the auxiliary heat dissipation device usually adopts a fan, and utilizes the air flow formed by the fan to air-cooling dissipate the heat generated by the vehicle-mounted intelligent device. However, this heat dissipation manner has low heat dissipation efficiency and poor heat dissipation effect, and requires ventilation holes disposed on the vehicle body to discharge the heat in the trunk, which leads to great changes to the vehicle body and high processing cost.

### SUMMARY

The present disclosure provides a refrigeration device and a vehicle.

According to one aspect of the present disclosure, there is provided a refrigeration device disposed in a trunk of a vehicle, and the refrigeration device including:
a semiconductor refrigeration sheet, having a cold end and a hot end which are disposed oppositely, wherein the hot end of the semiconductor refrigeration sheet is attached to an inner wall of the trunk, and the cold end of the semiconductor refrigeration sheet is disposed toward an inner space of the trunk.

According to another aspect of the present disclosure, there is also provided a vehicle, including the refrigeration device according to the above embodiment of the present disclosure.

According to the technique of the present disclosure, specific refrigeration requirement of the refrigeration object installed in the trunk can be met, and the semiconductor refrigeration sheet has no noise in the refrigeration process, which is beneficial to improve the ride experience of drivers and passengers; moreover, the cost of secondary processing of the vehicle body is reduced and the convenience of installation of the refrigeration device in the trunk is improved.

It should be understood that the content described in this section is neither intended to limit the key or important features of the embodiments of the present disclosure, nor intended to limit the scope of the present disclosure. Other features of the present disclosure will be readily understood through the following description.

### BRIEF DESCRIPTION OF THE DRAWINGS

The above and other features, advantages and aspects of various embodiments of the present disclosure will become more apparent when taken in conjunction with the accompanying drawings and with reference to the following detailed description. The same or similar reference signs refer to the same or similar elements throughout the drawings. In the drawings,
FIG. 1 shows a schematic diagram of the installation of a refrigeration device in a trunk according to an embodiment of the present disclosure;
FIG. 2 shows a schematic diagram of the installation of a refrigeration device in a trunk according to an embodiment of the present disclosure; and
FIG. 3 shows a schematic structural diagram of a semiconductor refrigeration sheet of a refrigeration device according to an embodiment of the present disclosure.

### Description of reference signs:

vehicle 1; trunk 1a; bottom wall lb;
refrigeration device 100;
semiconductor refrigeration sheet 10; cold end 10a; hot end 10b; first insulating heat-conducting sheet 111; second insulating heat-conducting sheet 112; N-type semiconductor element 121; P-type semiconductor element 122; first metal conductor 131; second metal conductor 132;
fan 20;
cold-conducting fin 30; and
refrigeration object 200.

### DETAILED DESCRIPTION

Exemplary embodiments of the present disclosure are described below in combination with the drawings, including various details of the embodiments of the present disclosure to facilitate understanding, which should be considered as exemplary only. Thus, those of ordinary skill in the art should realize that various changes and modifications can be made to the embodiments described here without departing from the scope and spirit of the present disclosure. Likewise, descriptions of well-known functions and structures are omitted in the following description for clarity and conciseness.

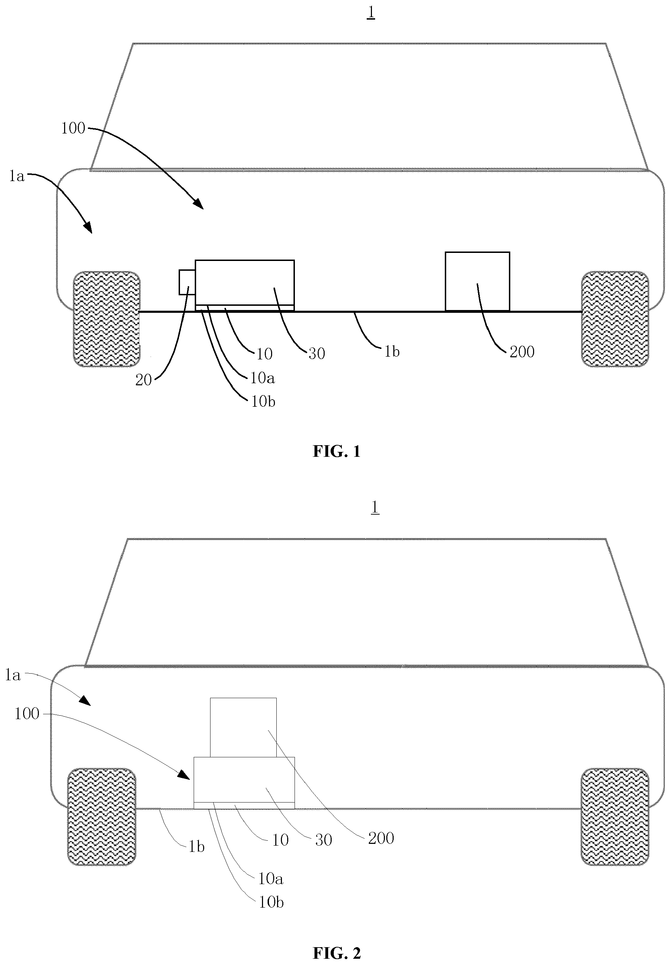

A refrigeration device 100 according to an embodiment of the present disclosure will be described below with reference to FIGS. 1 and 2.

As shown in the figures, the refrigeration device 100 according to the embodiment of the present disclosure is disposed in a trunk 1a of a vehicle 1.

Specifically, the refrigeration device 100 includes a semiconductor refrigeration sheet 10. The semiconductor refrigeration sheet 10 has a cold end 10a and a hot end 10b which are oppositely disposed. The hot end 10b of the semiconductor refrigeration sheet 10 is attached to an inner wall of the trunk 1a, and the cold end 10a of the semiconductor refrigeration sheet 10 is disposed toward an inner space of the trunk 1a.

In the embodiment of the present disclosure, a refrigeration object 200 can be placed in the trunk 1a, and the refrigeration object 200 can be any device, such as a vehicle-mounted intelligent device installed in the trunk 1a.

It can be understood that the semiconductor refrigeration sheet 10 includes an N-type semiconductor material and a P-type semiconductor material. The N-type semiconductor material and the P-type semiconductor material are coupled to form a thermocouple pair. In a case where electric current flows through the thermocouple pair, heat transfer occurs between the two ends of the semiconductor refrigeration sheet 10, that is, the heat is transferred from one end of the thermocouple pair to the other end of the thermocouple pair, such that a temperature difference occurs between the two ends of the semiconductor refrigeration sheet 10, thereby forming the cold end 10a and the hot end 10b at the two ends of the semiconductor refrigeration sheet 10, respectively.

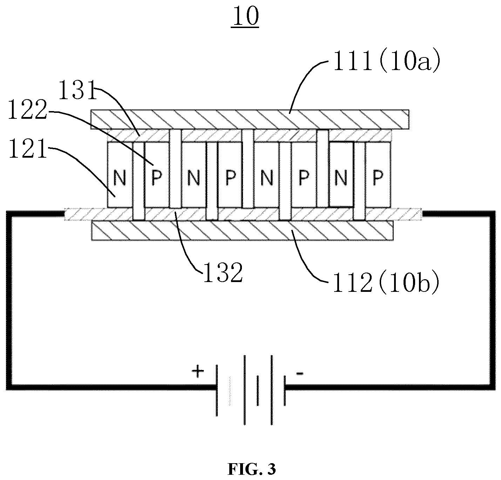

As shown in FIG. 3, in a specific example, the semiconductor refrigeration sheet 10 includes two insulating heat-conducting sheets disposed at intervals. A plurality of N-type semiconductor elements 121 and a plurality of P-type semiconductor elements 122 are disposed between the two insulating heat-conducting sheets. The N-type semiconductor elements 121 and the P-type semiconductor elements 122 are alternately arranged, and the ends of adjacent N-type semiconductor elements 121 and P-type semiconductor elements 122 are connected by metal conductors, such that the plurality of semiconductor elements are electrically conducted successively to form a complete circuit. The material of the metal conductors can be copper, aluminum, or other metal materials.

More specifically, the plurality of metal conductors includes first metal conductors 131 and second metal conductors 132. In the current flow direction, the first metal conductors 131 are connected between the first ends of the N-type semiconductor elements 121 and the first ends of the P-type semiconductor elements 122, and the plurality of first metal conductors 131 are attached to a first insulating heat-conducting sheet 111; the second metal conductors 132 are connected between the second ends of the P-type semiconductor elements 122 and the second ends of the N-type semiconductor elements 121, and the plurality of second metal conductors 132 are attached to a second insulating heat-conducting sheet 112. In the process of a current flowing, from an N-type semiconductor element 121 to a P-type semiconductor element 122, through the first metal conductor 131 between the N-type semiconductor element 121 and the P-type semiconductor element 122, the first metal conductor 131 absorbs heat. In the process of current flowing, from a P-type semiconductor element 122 to an N-type semiconductor element 121, through the second metal conductor 132 between the P-type semiconductor element 122 and the N-type semiconductor element 121, the second metal conductor 132 releases heat. Thus, in a case where a current is applied to the semiconductor refrigeration sheet 10, the first insulating heat-conducting sheet 111 attached to the plurality of first metal conductors 131 forms the cold end 10a of the semiconductor refrigeration sheet 10, and the second insulating heat-conducting sheet 112 attached to the plurality of second metal conductors 132 forms the hot end 10b of the semiconductor refrigeration sheet 10.

Furthermore, the refrigeration effect of the semiconductor refrigeration sheet 10 is related to the amount of the conduction current and the number of thermocouple pairs composed of N-type semiconductor elements 121 and P-type semiconductor elements 122. The amount of the conduction current and the number of thermocouple pairs composed of N-type semiconductor elements 121 and P-type semiconductor elements 122 can be correspondingly set according to the actual refrigeration requirement, and thus are not specifically limited in the embodiment of the present disclosure.

The cold end 10a and the hot end 10b of the semiconductor refrigeration sheet 10 are respectively formed on two opposite disposed outer surfaces of the semiconductor refrigeration sheet 10. The cold end 10a of the semiconductor refrigeration sheet 10 is disposed toward an inner space of the trunk 1a to refrigerate the inner space of the trunk 1a and the refrigeration object 200.

It can be understood that the trunk 1a of the vehicle 1 is usually defined by a vehicle body, and the vehicle body is usually made of metal. The hot end 10b of the semiconductor refrigeration sheet 10 can be directly attached to the metal vehicle body forming an inner wall of the trunk 1a. The inner wall of the trunk 1a can specifically be a bottom wall 1b of the trunk 1a or a side wall or a top wall of the trunk 1a.

According the embodiment of the present disclosure, the refrigeration device 100 is disposed in the trunk 1a of the vehicle 1, and the semiconductor refrigeration sheet 10 is disposed to refrigerate the refrigeration object 200 in the trunk 1a, and especially refrigerate the vehicle-mounted intelligent device installed in the trunk 1a. Because the semiconductor refrigeration sheet 10 has the characteristics of no noise, no vibration, no need of refrigerant, small volume, light weight, etc., and has the advantages of reliable operation, simple operation and convenient adjustment of quantity of cold, on the one hand, specific refrigeration requirement of the refrigeration object 200 installed in the trunk 1a can be met, and the semiconductor refrigeration sheet 10 has no noise in the refrigeration process, which is beneficial to improve the ride experience of drivers and passengers; on the other hand, it is beneficial to reduce the appearance dimension of the refrigeration device 100, thereby reducing the occupation of the space of the trunk 1a and ensuring the space utilization rate of the trunk 1a.

Furthermore, by attaching the hot end 10b of the semiconductor refrigeration sheet 10 to the inner wall of the trunk 1a, the heat emitted by the hot end 10b of the semiconductor refrigeration sheet 10 can be directly conducted to the vehicle body forming the inner wall of the trunk 1a, and the heat can be dissipated to the outside through the metal vehicle body. Thus, on the one hand, the heat dissipation effect of the semiconductor refrigeration sheet can be improved, thereby improving the refrigeration efficiency of the refrigeration device 100; on the other hand, compared with the prior art solution of refrigerating the refrigeration device 100 by disposing a fan 20 in the trunk 1a, the refrigeration device 100 of the embodiment of the present disclosure does not need to be provided with ventilation holes or other structures on the trunk 1a in the process of refrigerating the refrigeration object 200, thus reducing the cost of secondary processing of the vehicle body and improving the convenience of installation of the refrigeration device 100 in the trunk 1a.

As shown in FIGS. 1 and 2, in an implementation, the hot end 10b of the semiconductor refrigeration sheet 10 is attached to the bottom wall 1b of the trunk 1a.

Illustratively, heat-conducting silica gel can be disposed between the hot end 10b of the semiconductor refrigeration sheet 10 and the bottom wall 1b of the trunk 1a, to improve the heat-conducting property and heat-conducting efficiency between the semiconductor refrigeration sheet 10 and the bottom wall 1b of the trunk 1a.

The embodiment of the present disclosure does not specifically limit the connection and fixing mode of the semiconductor refrigeration sheet 10 on the bottom wall 1b of the trunk 1a. For example, the semiconductor refrigeration sheet 10 can be fixed to the bottom wall 1b of the trunk 1a by a fixing support connected with the bottom wall 1b of the trunk 1a.

It can be understood that the cold end 10a and the hot end 10b of the semiconductor refrigeration sheet 10 are disposed oppositely, the hot end 10b of the semiconductor refrigeration sheet 10 is disposed downward and attached to the bottom wall 1b of the trunk 1a, and correspondingly, the hot end 10b of the semiconductor refrigeration sheet 10 is disposed upward and toward the inner space of the trunk 1a, such that the quantity of cold generated by the cold end 10a of the semiconductor refrigeration sheet 10 refrigerates the inner space of the trunk 1a.

According to the above implementation, by attaching the hot end 10b of the semiconductor refrigeration sheet 10 to the bottom wall 1b of the trunk 1a, on the one hand, a large contact area can be ensured between the hot end 10b of the semiconductor refrigeration sheet 10 and the inner wall of the trunk 1a, and on the other hand, the fixing effect of the semiconductor refrigeration sheet 10 in the trunk 1a can be improved to ensure the structural stability.

As shown in FIG. 1, in an implementation, the cold end 10a of the semiconductor refrigeration sheet 10 is disposed at a preset distance from the refrigeration object 200.

In other words, the cold end 10a of the semiconductor refrigeration sheet 10 and the refrigeration object 200 are disposed in a non-contact manner, and the cold end 10a of the semiconductor refrigeration sheet 10 refrigerates the inner space of the trunk 1a as a whole to reduce the temperature of the working environment of the refrigeration object 200, thereby achieving the purpose of refrigerating the refrigeration object 200.

It should be noted that the preset distance between the cold end 10a of the semiconductor refrigeration sheet 10 and the refrigeration object 200 can be adjusted according to the actual situation. For example, the distance between the both can be set by comprehensively considering the actual size of the trunk 1a, the refrigeration quantity required by the refrigeration object 200, and the refrigeration effect of the refrigeration device 100, as long as the quantity of cold of the semiconductor refrigeration sheet 10 can meet the refrigeration requirement of the refrigeration object 200.

Through the above implementation, the semiconductor refrigeration sheet 10 can be used for refrigerating the inner space of the trunk 1a as a whole, and then refrigerating the working environment of the refrigeration object 200, which is beneficial to ensure that the working environment of the refrigeration object 200 is at a stable working temperature for a long time, thereby improving the working stability of the refrigeration object 200.

As shown in FIG. 1, in an implementation, the refrigeration device 100 further includes a fan 20. The fan 20 is disposed adjacent to the cold end 10a of the semiconductor refrigeration sheet 10, and the air-out direction of the fan 20 is disposed toward the refrigeration object 200.

Illustratively, the refrigeration device 100 further includes a heat-conducting fin. The heat-conducting fin is installed at the cold end 10a of the semiconductor refrigeration sheet 10 and is used for conducting the quantity of cold of the semiconductor refrigeration sheet 10. The fan 20 is installed on the heat-conducting fin, and the air-out direction of the fan 20 is disposed toward the refrigeration object 200.

Thus, the quantity of cold generated by the cold end 10a of the semiconductor refrigeration sheet 10 can be driven by the air flow formed by the fan 20 to form cold air, and the flow direction of the cold air is disposed toward the refrigeration object 200, so as to meet the specific refrigeration requirement of the refrigeration object 200 and improve the refrigeration effect on the refrigeration object 200.

As shown in FIG. 2, in an implementation, the cold end 10a of the semiconductor refrigeration sheet 10 is attached to at least part of the refrigeration object 200.

Illustratively, the hot end 10b of the semiconductor refrigeration sheet 10 is attached to the bottom wall 1b of the trunk 1a, and the refrigeration object 200 is installed over the cold end 10a of the semiconductor refrigeration sheet 10, that is, the lower surface of the refrigeration object 200 is attached to an outer surface of the cold end 10a of the semiconductor refrigeration sheet 10. The attachment area between the cold end 10a of the semiconductor refrigeration sheet 10 and the refrigeration object 200 is provided with heat-conducting silica gel, to improve the heat-conducting property between the cold end 10a of the semiconductor refrigeration sheet 10 and the refrigeration object 200.

In addition, the cold end 10a of the semiconductor refrigeration sheet 10 can be fixedly connected to the refrigeration object 200 by fasteners or other ways to improve the connection stability between the both and ensure the stable attachment between the both.

According to the above implementation, by attaching the cold end 10a of the semiconductor refrigeration sheet 10 to the refrigeration object 200, the cold end 10a of the semiconductor refrigeration sheet 10 can directly absorb the heat dissipated by the refrigeration object 200, thereby realizing rapid refrigeration of the refrigeration object 200, ensuring the refrigeration effect of the refrigeration device 100 on the refrigeration object 200, and realizing the specific refrigeration of the refrigeration object 200. Furthermore, the integration of the refrigeration device 100 and the refrigeration object 200 is realized, thereby reducing the occupation of the inner space of the trunk 1a and facilitating to improve the space utilization rate of the trunk 1a.

In an implementation, there are a plurality of semiconductor refrigeration sheets 10, and the plurality of semiconductor refrigeration sheets 10 are disposed at intervals in a preset direction.

In an implementation, each of the hot ends 10b of the plurality of semiconductor refrigeration sheets 10 is attached to the bottom wall 1b of the trunk 1a, and the plurality of semiconductor refrigeration sheets 10 can be arranged in an array, such that the plurality of semiconductor refrigeration sheets 10 form a uniform refrigeration effect. The outer surface of the refrigeration object 200 can be attached to the cold ends 10a of the plurality of semiconductor refrigeration sheets 10 at the same time.

In another example, the cold ends 10a of the plurality of semiconductor refrigeration sheets 10 are attached to the outer surface of the refrigeration object 200. The hot ends 10b of a part of the plurality of the semiconductor refrigeration sheets 10 are attached to the inner wall of the trunk 1a, and the hot ends 10b of the other semiconductor refrigeration sheets 10 are disposed in an air spaced manner in the inner space of the trunk 1a. Thus, the cold ends 10a of the plurality of semiconductor refrigeration sheets 10 can fully absorb the heat generated by the refrigeration object 200, thereby improving the refrigeration effect on the refrigeration object 200.

It should be noted that the arrangement of the plurality of semiconductor refrigeration sheets 10 on the outer surface of the refrigeration object 200 can be set correspondingly according to quantity of heat emitted from different areas of the refrigeration object 200. For example, for the areas, of the refrigeration object 200, where the quantity of heat emitted is large, the arrangement density of the semiconductor refrigeration sheets 10 is correspondingly high; and for the areas, of the refrigeration object 200, where the quantity of heat emitted is small, the arrangement density of the semiconductor refrigeration sheets 10 is correspondingly reduced.

In an implementation, the semiconductor refrigeration sheets 10 are electrically connected to a power supply system of the vehicle 1.

Illustratively, the semiconductor refrigeration sheet 10 is electrically connected to a direct current power supply module in the power supply system of the vehicle 1, to supply power to the semiconductor refrigeration sheet 10 through the direct current power supply module.

Further, a control apparatus of the vehicle 1 can adjust the refrigeration quantity of the semiconductor refrigeration sheet 10 by adjusting the amount of the current supplied by the direct current power supply module to the refrigeration sheet.

Therefore, the refrigeration quantity of the refrigeration device 100 can be adjusted for different temperature conditions, such that the refrigeration object 200 is in a working environment with a relatively stable temperature.

In an implementation, the refrigeration device 100 further includes a direct current power supply apparatus electrically connected to the semiconductor refrigeration sheets 10.

Illustratively, the direct current power supply apparatus can be a battery, for example, the direct current power supply apparatus can be a primary battery, a zinc-manganese dry battery, a lithium battery, or any other kind of batteries, as long as the direct current power supply requirement of the semiconductor refrigeration sheets 10 can be met.

Through the above implementation, the refrigeration device 100 can work independently without an external connected power supply, thus improving the use convenience of the refrigeration device 100, and being beneficial to improving the application scene and application scope of the refrigeration device 100.

According to another embodiment of the present disclosure, a vehicle 1 is also provided.

As shown in FIGS. 1 and 2, the vehicle 1 according to an embodiment of the present disclosure includes the refrigeration device 100 according to the above embodiment of the present disclosure.

Illustratively, the vehicle 1 of the embodiment of the present disclosure can be a normal vehicle, an automatic driving vehicle, a driving training vehicle, or any other vehicle.

According to the vehicle 1 of the embodiment of the present disclosure, by using the refrigeration device 100 according to the above embodiment of the present disclosure, on the one hand, the specific refrigeration requirement of the refrigeration object 200 installed in the trunk 1a can be met, and the semiconductor refrigeration sheet 10 produces no noise in refrigeration process, which is beneficial to improving the ride experience of drivers and passengers; on the other hand, it is beneficial to reduce the appearance dimension of the refrigeration device 100, thereby reducing the occupation of the space of the trunk 1a and ensuring the space utilization rate of the trunk 1a. Furthermore, compared with the prior art solution in which the refrigeration device 100 is refrigerated by a fan 20 disposed in the trunk 1a, the vehicle 1 of the embodiment of the present disclosure does not require any ventilation hole or other structures disposed on the trunk 1a, thereby reducing the cost of secondary processing of the vehicle body and improving the convenience of installation of the refrigeration device 100 in the trunk 1a.

In an implementation, the vehicle 1 further includes a vehicle-mounted intelligent device. The vehicle-mounted intelligent device is disposed in the trunk 1a of the vehicle 1 and is the refrigeration object 200 corresponding to the refrigeration device 100.

In a specific example, the vehicle 1 can be an automatic driving vehicle and the vehicle-mounted intelligent device can be a vehicle-mounted computing unit. The vehicle-mounted computing unit is used for performing relevant computing processing to realize the automatic driving function of the vehicle 1. Specifically, the vehicle-mounted computing unit can include computer hardware, such as a central processing unit, a graphics processing unit, and a field programmable gate array, and respective computer hardware will generate a lot of heat under the condition of high load operation. The vehicle-mounted computing unit can be integrated with the refrigeration device 100, for example, the vehicle-mounted computing unit can be attached to the cold end 10a of the semiconductor refrigeration sheet 10 of the refrigeration device 100, to meet the specific refrigeration requirement of the vehicle-mounted computing unit.

Other constituents of the vehicle 1 of the embodiment of the present disclosure can adopt various technical solutions known to those of ordinary skill in the art now and in the future, and will not be described in detail herein.

In the description of this specification, it should be understood that the orientation or positional relationships indicated by the terms "central," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," etc. are orientation or positional relationships shown based on the drawings, and they are only for the convenience of describing the present disclosure and simplifying the description, rather than indicating or implying that the apparatus or element must have a specific orientation, or must be constructed and operated in a specific orientation, and therefore they are not to be construed as a limitation to the present disclosure.

In addition, the terms "first" and "second" are only used for descriptive purposes, and are not to be construed as indicating or implying relative importance or implicitly indicating the number of indicated technical features. Thus, the features defined with "first" and "second" may explicitly or implicitly include one or more of these features. In the description of the present disclosure, "a plurality of" means two or more, unless otherwise expressly and specifically defined.

In the present disclosure, unless otherwise expressly specified or defined, the terms "install," "link," "connect," "fix," etc. should be understood in the broad senses, for example, the terms may be a fixed connection, a detachable connection, or integration; the terms may be a mechanical connection, an electrical connection, or communication; and the terms may be a direction connection, an indirect connection through an intermediate medium, or internal communication between two elements or an interaction therebetween. For those of ordinary skill in the art, the specific meanings of the above terms in the present disclosure may be understood according to specific circumstances.

In the present disclosure, unless otherwise expressly specified or defined, a first feature being "on" or "under" a second feature indicates not only a direct contact between the first and second features, but also an indirect contact therebetween through another feature. Further, the first feature being "on," "above," or "over" the second feature indicates that the first feature is directly or obliquely above the second feature, or simply means that the first feature is higher in level than the second feature. The first feature being "under," "below," or "beneath" the second feature indicates that the first feature is directly or obliquely below the second feature, or simply means that the first feature is lower in level than the second feature.

The above disclosure provides many different implementations or examples for implementing different structures of the present disclosure. In order to simplify the disclosure of the present disclosure, components and arrangements of specific examples have been described above. Of course, they are only examples and are not intended to limit the present disclosure. In addition, the present disclosure may repeat reference signs and/or reference letters in different examples, which repetition is for the sake of simplicity and clarity, but not to indicate the relationship between the various implementations and/or arrangements discussed.

The above-mentioned specific implementations are not to be construed as limiting the scope of the present disclosure. It will be apparent to those skilled in the art that various modifications, combinations, sub-combinations and substitutions are possible, depending on design requirements and other factors. Any modifications, equivalent substitutions and improvements, and the like within the spirit and principle of the present disclosure are intended to be included within the scope of the present disclosure.

## Claims

1. A refrigeration device (100), disposed in a trunk (1a) of a vehicle (1) and comprising:
a semiconductor refrigeration sheet (10), having a cold end (10a) and a hot end (10b) which are disposed oppositely, wherein the hot end (10b) of the semiconductor refrigeration sheet (10) is attached to an inner wall of the trunk (1a), and the cold end (10a) of the semiconductor refrigeration sheet (10) is disposed toward an inner space of the trunk (1a).

2. The refrigeration device (100) of claim 1, wherein the hot end (10b) of the semiconductor refrigeration sheet (10) is attached to a bottom wall (1b) of the trunk (1a).

3. The refrigeration device (100) of claim 1 or 2, wherein a refrigeration object (200) is placed in the trunk (1a) and the cold end (10a) of the semiconductor refrigeration sheet (10) is disposed at a preset distance from the refrigeration object (200).

4. The refrigeration device (100) of claim 3, further comprising:
a fan (20), disposed adjacent to the cold end (10a) of the semiconductor refrigeration sheet (10), wherein an air-out direction of the fan (20) is disposed toward the refrigeration object (200).

5. The refrigeration device (100) of any of claims 1 to 4, wherein a refrigeration object (200) is placed in the trunk (1a) and the cold end (10a) of the semiconductor refrigeration sheet (10) is attached to at least part of the refrigeration object (200).

6. The refrigeration device (100) of any of claims 1 to 5, wherein there are a plurality of semiconductor refrigeration sheets (10) and the plurality of semiconductor refrigeration sheets (10) are disposed at intervals in a preset direction.

7. The refrigeration device (100) of any one of claims 1 to 6, wherein the semiconductor refrigeration sheet (10) is electrically connected to a power supply system of the vehicle (1).

8. The refrigeration device (100) of any one of claims 1 to 7, further comprising:
a direct current power supply apparatus, electrically connected to the semiconductor refrigeration sheet (10).

9. A vehicle (1), comprising the refrigeration device (100) of any one of claims 1 to 8.

10. The vehicle (1) of claim 9, further comprising:
a vehicle-mounted intelligent device, disposed in a trunk (1a) of the vehicle (1); wherein the vehicle-mounted intelligent device is a refrigeration object (200) corresponding to the refrigeration device (100).
